# EUROPEAN PATENT APPLICATION

(11) **EP 4 712 742 A1**
(43) Date of publication of application: **18.03.2026**
(21) Application number: 24200646.8
(22) Date of filing: 16.09.2024
(51) Int. Cl.: H10K 30/40, H10K 30/86, H10K 85/60

(54) **COMPOUNDS FORMING HOLE-TRANSPORTING SELF-ASSEMBLED MONOLAYER**

(71) Applicant: Helmholtz-Zentrum Berlin für Materialien und Energie GmbH, 14109 Berlin (DE); Kaunas University of Technology, 44249 Kaunas (LT)
(72) Inventor: Musiienko, Artem, 14109 Berlin (DE); Malinauskas, Tadas, 49317 Kaunas (LT); Getautis, Vytautas, 51390 Kaunas (LT); Marcinskas, Mantas, 54340 Zemaitkiemis, Kauno raj. (LT); Musteikis, Skirmantas, 26102 Elektrénai (LT); Frasca, Chiara, 14109 Berlin (DE); Stacchini, Valerio, 14109 Berlin (DE); Abate, Antonio, 14109 Berlin (DE); Rastgoo, Madineh, 80125 Napoli (IT)
(74) Representative: Schulz Junghans Patentanwälte PartGmbB

(57) **Abstract**

The present invention relates to a compound is of formula (I) 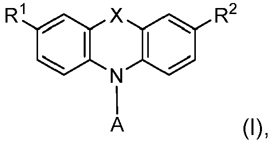 wherein
X is selected from the group consisting of -S-, -Se-, -O-, -Te-, -NH-, -C(CH₃)₂-, -S(=O)-, -(O=)S(=O)-, and -C(=O)-;
A is an anchoring group, wherein the anchoring group is selected from the groups consisting of
• -C₁-C₁₈-alkyl-PO₃H₂, -C₁-C₁₈-alkyl-COOH, -C₁-C₁₈-alkyl-B(OH)₂,
• 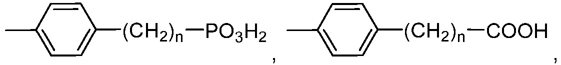 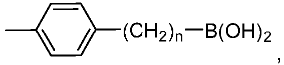 wherein n is 0, 1 or 2,
• 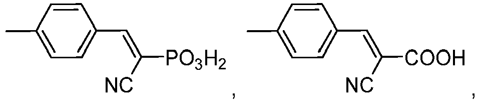 •

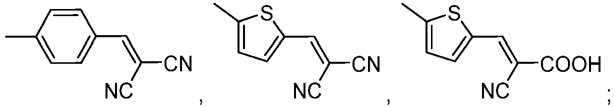

R¹ and R² are each selected from a mono-hetero aromatic moiety or a di-hetero aromatic moiety.

The invention further relates to a method for preparing a self-assembled monolayer for perovskite solar cells.

## Description

### Background

Perovskites are set on track to radically change the world of semiconductors and in particular of photovoltaics. The two major issues remain stability and toxicity. To address the toxicity of Lead-containing perovskite, research is ongoing on non-toxic tin based perovskites. Despite the efforts and the good potential, tin perovskite is still lagging behind lead perovskite. The reasons are mainly the fast crystallization and the oxidation of Sn(!!) to Sn(IV) that leads to p-doping of the absorber layer. Tin-based perovskites present shallower energy levels with respect to Lead-based perovskites. This makes it necessary to develop transport layers with the right energetic alignment. Until now, PEDOT as HTL and C60 as ETL have been used for the big majority of tin perovskite devices, despite the significative misalignment. While the standard hole transport layer is PEDOT, efforts have been made to use self-assembled monolayers as hole selective layers, following the numerous studies on hole-transport layer self-assembled monolayers (HTL SAMs) in Lead Perovskite. Song et al. in 2021 reached a power conversion efficiency (PCE) of 6.5% in the first attempt to apply a self-assembled monolayer on a DMSO-processed tin perovskite. The goal was achieved with a preheating step of indium tin oxide (ITO) up to 400 °C and a two-step process for perovskite deposition. The molecules used to functionalize ITO was [2-(3,6-dimethoxy-9Hcarbazol-9-yl)ethyl]phosphonic acid (MeO-2PACz) SAM. In another work by Atkas et al. 5.8% PCE was achieved with a DMSO-free solvent system for FASnl3 deposited with a one-step method on MeO-2PACz.

Based on the above-mentioned state of the art, the objective of the present invention is to provide means and methods to new compounds forming self-assembled monolayers for development of cheap, non-toxic photovoltaics based on tin perovskite. This objective is attained by the subject-matter of the independent claims of the present specification, with further advantageous embodiments described in the dependent claims, examples, figures and general description of this specification.

### Summary of the Invention

A first aspect of the invention relates to a compound is of formula (I) 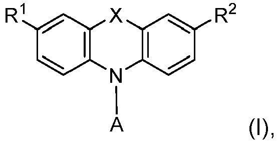 wherein
X is selected from the group consisting of -S-, -Se-, -O-, -Te-, -NH-, -C(CH₃)₂-, -S(=O)-, -(O=)S(=O)-, and -C(=O)-;
A is an anchoring group, wherein the anchoring group is selected from the groups consisting of
   - -C₁-C₁₈-alkyl-PO₃H₂, -C₁-C₁₈-alkyl-COOH, -C₁-C₁₈-alkyl-B(OH)₂,
   - 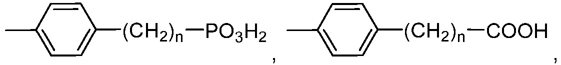 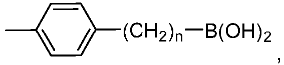 wherein n is 0, 1 or 2,
   - 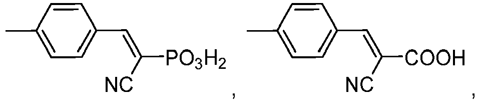
   - 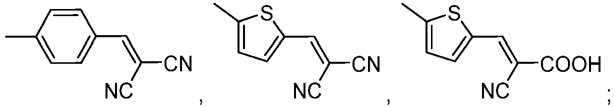
R¹ and R² are each selected from a mono-hetero aromatic moiety or a di-hetero aromatic moiety.

A second aspect of the invention relates to a method for preparing a self-assembled monolayer for perovskite solar cells comprising the steps of
a. providing a compound according to the first aspect of the invention,
b. providing an ITO substrate,
c. activating the ITO substrate,
d. depositing the compound according to the first aspect of the invention onto the substrate,
e. annealing the substrate.

### Terms and definitions

### General

For purposes of interpreting this specification, the following definitions will apply and whenever appropriate, terms used in the singular will also include the plural and vice versa. In the event that any definition set forth below conflicts with any document incorporated herein by reference, the definition set forth shall control.

The terms "comprising", "having", "containing", and "including", and other similar forms, and grammatical equivalents thereof, as used herein, are intended to be equivalent in meaning and to be open-ended in that an item or items following any one of these words is not meant to be an exhaustive listing of such item or items, or meant to be limited to only the listed item or items. For example, an article "comprising" components A, B, and C can consist of (i.e., contain only) components A, B, and C, or can contain not only components A, B, and C but also one or more other components. As such, it is intended and understood that "comprises" and similar forms thereof, and grammatical equivalents thereof, include disclosure of embodiments of "consisting essentially of" or "consisting of."

Where a range of values is provided, it is understood that each intervening value, to the tenth of the unit of the lower limit, unless the context clearly dictates otherwise, between the upper and lower limit of that range and any other stated or intervening value in that stated range, is encompassed within the disclosure, subject to any specifically excluded limit in the stated range. Where the stated range includes one or both of the limits, ranges excluding either or both of those included limits are also included in the disclosure.

Reference to "about" a value or parameter herein includes (and describes) variations that are directed to that value or parameter per se. For example, description referring to "about X" includes description of "X."

As used herein, including in the appended claims, the singular forms "a", "or" and "the" include plural referents unless the context clearly dictates otherwise.

"And/or" where used herein is to be taken as specific recitation of each of the two specified features or components with or without the other. Thus, the term "and/or" as used in a phrase such as "A and/or B" herein is intended to include "A and B," "A or B," "A" (alone), and "B" (alone). Likewise, the term "and/or" as used in a phrase such as "A, B, and/or C" is intended to encompass each of the following aspects: A, B, and C; A, B, or C; A or C; A or B; B or C; A and C; A and B; B and C; A (alone); B (alone); and C (alone).

The term *mono-hetero aromatic moiety* in the context of the present specification relates to a hetero aromatic moiety consisting of a single aromatic cyclic core comprising at least one heteroatom. The mono-hetero aromatic moiety is further substituted or unsubstituted. In particular, the mono-hetero aromatic moiety is unsubstituted. Examples include but are not limited to thiophene, furan, pyrrole, pyridine, pyrimidine, pyrazine, selenophene or imidazole.

The term *di-hetero aromatic moiety* in the context of the present specification relates to a hetero aromatic moiety consisting of at least two aromatic cycles, wherein the aromatic cycles are directly attached to one another sharing a bond or are connected to each other via a separating bond, and wherein the di-hetero aromatic moiety comprises at least 1 heteroatom.

In particular the at least two aromatic cycles of the di-hetero aromatic moiety are identical to one another. The di-hetero aromatic moiety is further substituted or unsubstituted. In particular, the di-hetero aromatic moiety is unsubstituted. Examples include but are not limited to chinoline, purine, acridine, benzimidazole, 3-methylbenzo[b]thiophene, and thieno[3,2-b]thiophene, 2,2'-bithiophene.

Any patent document cited herein shall be deemed incorporated by reference herein in its entirety.

The formulae of the present specification follow the convention of organic chemistry to not show hydrogen atoms on carbon scaffolds. Carbon is tetravalent and bonds not shown are assumed to be hydrogen unless shown otherwise. Hydrogen can be exchanged for deuterium without changing the bulk chemical properties of the molecule. Unless explicitly stated otherwise herein, the disclosure of a formula showing, explicitly or implicitly by the convention restated in the first sentence of this paragraph, encompasses molecules in which one or several of the hydrogen atoms are exchanged for deuterium.

The term *alkyl* in the context of the present specification relates to a saturated linear, or branched hydrocarbon, wherein in certain embodiments one carbon-carbon bond may be unsaturated.

The term *C₁-C₃ alkyl* in the context of the present specification relates to a saturated linear or branched hydrocarbon having 1, 2, or 3 carbon atoms. Non-limiting examples for a *C₁-C₃* alkyl are methyl, ethyl, propyl, prop-2-enyl.

A *C₁-C₆ alkyl* in the context of the present specification relates to a saturated linear or branched hydrocarbon having 1, 2, 3, 4, 5 or 6 carbon atoms. Non-limiting examples for a C₁-C₆ alkyl include the examples given for *C₁-C₃* alkyl above, and additionally n-pentyl, 2-methylbutyl, 3-methylbutyl, 1,1-dimethylpropyl, 1,2-dimethylpropyl, and 1,2-dimethylpropyl.

A C₁-C₁₀ alkyl in the context of the present specification relates to a saturated linear or branched hydrocarbon having 1 to 10 carbon atoms. Non-limiting examples for a C₁-C₁₀ alkyl include the examples given for *C₁-C₃* alkyl and C₁-C₆ alkyl above, and additionally octanyl, nonanyl, 2-ethylhexanyl, 3-methylheptanyl, 3-ethylheptanyl, 4-methyloctanyl, 3, 4-dimentyloctanyl.

A *C₁-C₁₈ alkyl* in the context of the present specification relates to a saturated linear or branched hydrocarbon having 1 to 18 carbon atoms. Non-limiting examples for a C₁-C₁₈ alkyl include the examples given for *C₁-C₃* alkyl, C₁-C₆ alkyl and C₁-C₁₀ above, and additionally octadecanyl, heptadecanyl, hexadecanyl, pentadecanyl, tetradecanyl, tridecanyl, dodecanyl, undecanyl, 8-methylheptadecanyl, 2,3,4-trimethylpentadecaynl, 2,4,6-trimethylhexadecanyl, 2,4-diethyltridecanyl, 4,5-diethyltetradecanyl and 2-methyl-4,5,6-ethylundecanyl.

Where used in the context of chemical formulae, the following abbreviations may be used: Me is methyl CH₃, *Et* is ethyl -CH₂CH₃, *Prop* is propyl -(CH₂)₂CH₃ (n-propyl, n-pr) or -CH(CH₃)₂ (iso-propyl, i-pr), *but* is butyl -C₄H₉, -(CH₂)₃CH₃, -CHCH₃CH₂CH₃, -CH₂CH(CH₃)₂ or -C(CH₃)₃.

### Detailed Description of the Invention

A first aspect of the invention relates to a compound comprising formula (I) 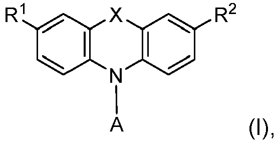 wherein
X is selected from the group consisting of -S-, -Se-, -O-, -Te-, -NH-, -C(CH₃)₂-, -S(=O)-, -(O=)S(=O)-, and -C(=O)-;
A is an anchoring group, wherein the anchoring group is selected from the groups consisting of
   - -C₁-C₁₈-alkyl-PO₃H₂, -C₁-C₁₈-alkyl-COOH, -C₁-C₁₈-alkyl-B(OH)₂,
   - 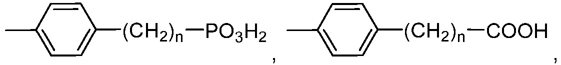 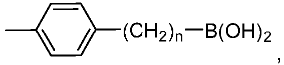 wherein n is 0, 1 or 2,
   - 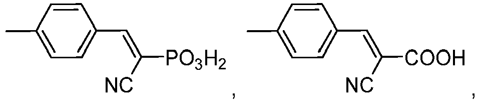
   - 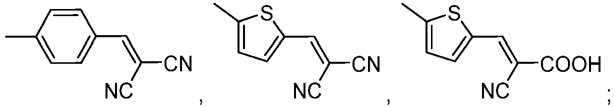
R¹ and R² are each selected from a mono-hetero aromatic moiety or a di-hetero aromatic moiety.

SAMs based on molecules of formula (I) improve charge carrier transport and extraction, due to the electron-rich core. This offers an advantage over the traditional carbazole-based SAMs.In certain embodiments, the compound comprises formula (I) 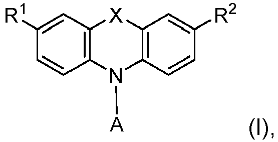 wherein
X is selected from the group consisting of-S-, -Se-, -O-, -Te-, -NH-, -C(CH₃)₂-, -S(=O)-, -(O=)S(=O)-, and -C(=O)-;
A is an anchoring group, wherein the anchoring group is selected from the groups consisting of
   - -C₁-C₁₈-alkyl-PO₃H₂, -C₁-C₁₈-alkyl-COOH, -C₁-C₁₈-alkyl-B(OH)₂,
   - 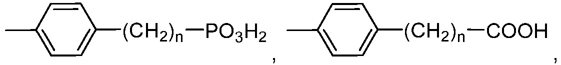 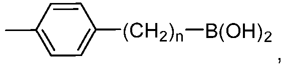 wherein n is 0, 1 or 2,
   - 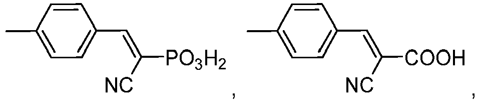
R¹ and R² are each selected from a mono-hetero aromatic moiety or a di-hetero aromatic moiety.

In certain embodiments, the compound forms self-assembled monolayers.

In certain embodiments, X is selected from -S-, -Se-, -O-, -Te-, -NH-, and -C(CH₃)₂-.

In certain embodiments, X is selected from -S-, -Se-, and -O-.

In certain embodiments, X is selected from - S- and -O-.

In certain embodiments, X is -S-.

Phenothiazine based SAMs significantly improve charge carrier transport and extraction, due to the electron-rich phenothiazine, with its electron donating atoms sulphur and nitrogen This offers an advantage over the traditional carbazole-based SAMs.

Thiazine based molecules forming self-assembled monolayers exhibit superior performances, specifically superior power conversion efficiency (PCE), compared to MeO-2PACz and PEDOT, in tin based perovskite solar cells, without any additional modification components.

In certain embodiments A is selected from the groups consisting of
- -C₁-C₁₈-alkyl-PO₃H₂, -C₁-C₁₈-alkyl-COOH, -C₁-C₁₈-alkyl-B(OH)₂,
- 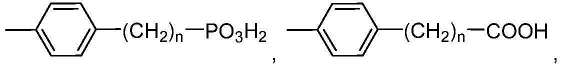 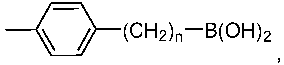 wherein n is 0, 1 or 2,
-

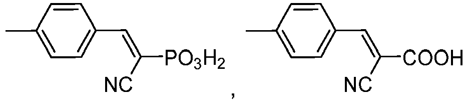

In certain embodiments, A is selected from the groups consisting of
- -C₁-C₁₈-alkyl-PO₃H₂, -C₁-C₁₈-alkyl-COOH,
- 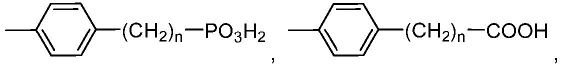 wherein n is 0, 1 or 2,
-

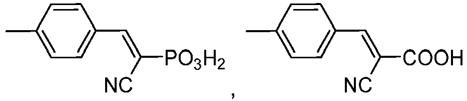

In certain embodiments, A is selected from the groups consisting of
- -C₁-C₁₀-alkyl-PO₃H₂, -C₁-C₁₀-alkyl-COOH,
- 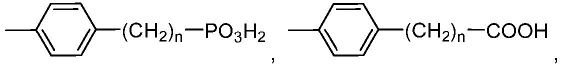 wherein n is 0, 1 or 2,
-

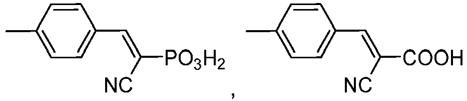

In certain embodiments, A is selected from the groups consisting of
- -C₁-C₁₀-alkyl-PO₃H₂,
- 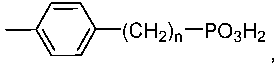 wherein n is 0, 1 or 2, and
-

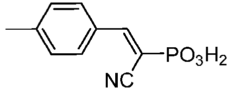

Phosphonic acid containing anchoring groups form a more stable bond with metal oxide surfaces and have an increased stability against hydrolysis.

In certain embodiments, A is selected from the groups consisting of
- -C₁-C₆-alkyl-PO₃H₂,
- 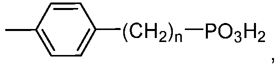 wherein n is 0, 1 or 2, and
-

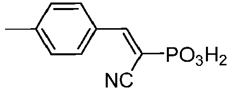

In certain embodiments, A is selected from the group consisting of -C₁-C₆-alkyl-PO₃H₂.

In certain embodiments, A is selected from the group consisting of -C₁-C₄-alkyl-PO₃H₂.

In certain embodiments, the mono-hetero aromatic moiety of R¹ and R² comprises 5 to 9 atoms.

In certain embodiment, the mono-hetero aromatic moiety of R¹ and R² comprises 1 or 2 heteroatoms.

In certain embodiments, the mono-hetero aromatic moiety of R¹ and R² comprises 5 or 6 atoms.

In certain embodiments, the mono-hetero aromatic moiety of R¹ and R² comprises 3 to 5 carbon atoms.

In certain embodiments, the mono-hetero aromatic moiety of R¹ and R² comprises 3 to 5 carbon atoms and 1 or 2 heteroatoms.

In certain embodiments, the mono-hetero aromatic moiety of R¹ and R² comprises 3 to 5 carbon atoms and 1 or 2 heteroatoms.

In certain embodiments, the mono-hetero aromatic moiety of R¹ and R² comprises 3 to 5 carbon atoms and 1 or 2 heteroatoms selected from N, NH, S, O, and Se.

In certain embodiment, the di-hetero aromatic moiety of R¹ and R² comprises 8 to 12 atoms.

In certain embodiment, the di-hetero aromatic moiety of R¹ and R² comprises 8 to 10 atoms.

In certain embodiments, the di-hetero aromatic moiety of R¹ and R² comprises 1 or 2 heteroatoms.

In certain embodiment, the di-hetero aromatic moiety of R¹ and R² comprises 6 to 8 carbon atoms.

In certain embodiment, the di-hetero aromatic moiety of R¹ and R² comprises 6 to 8 carbon atoms and 1 or 2 heteroatoms.

In certain embodiment, the di-hetero aromatic moiety of R¹ and R² comprises 6 to 8 carbon atoms and 1 or 2 heteroatoms selected from N, NH, S, O, and Se.

In certain embodiments, R¹ and R² are selected from any one of the moieties

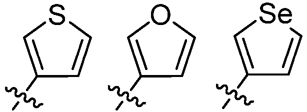

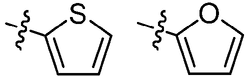

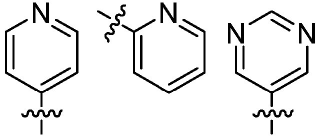

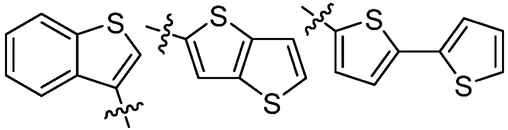

In certain embodiments, R¹ and R² are selected from any one of the moieties

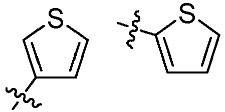

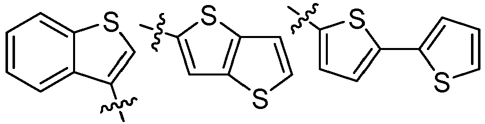

Sulphur rich substituents contribute to the enhancement of charge carrier transport and extraction in the self-assembled monolayer (SAM).

In certain embodiments, R¹ and R² are selected from any one of the moieties

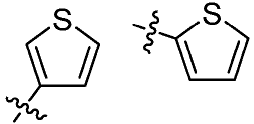

In certain embodiment, the compound is of formula (II) 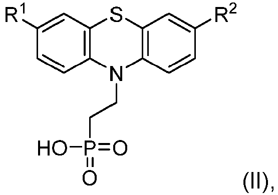 wherein R¹ and R² are each selected from a mono-hetero aromatic moiety or a di-hetero aromatic moiety.

In certain embodiment, the compound is of formula (II) 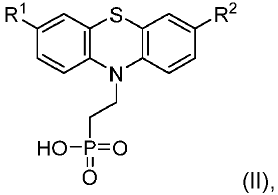 wherein R¹ and R² are selected from any one of the moieties

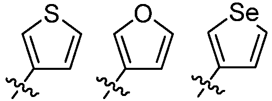

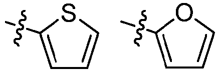

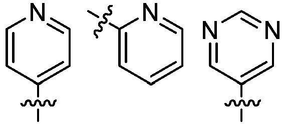

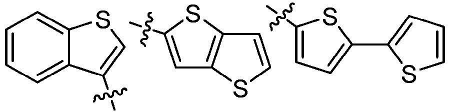

In certain embodiment, the compound is of formula (II) 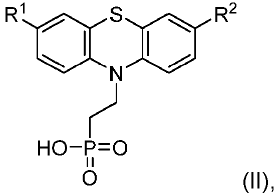 wherein R¹ and R² are selected from any one of the moieties

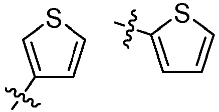

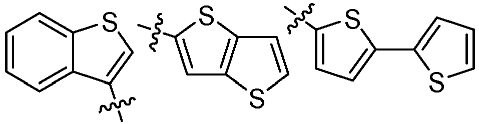

In certain embodiment, the compound is of formula (II) 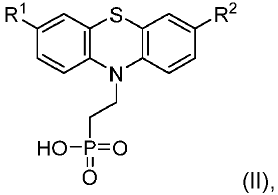 wherein R¹ and R² are selected from any one of the moieties

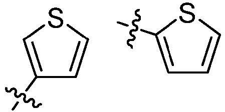

In certain embodiments, the compound is of formula (III) 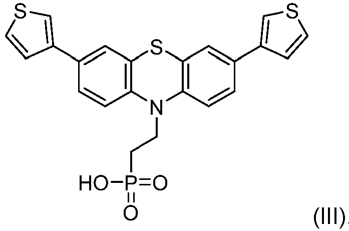 {2-[3,7-Di(thiophen-3-yl)-10H-phenothiazin-10-yl]ethyl}phosphonic acid (2T-TPZ, III), is tailored to improve chemical interaction with tin perovskite and favour crystallisation due to sulphur-rich substituents. The functional group determines the characteristics of the SAM. 2T-TPZ, containing the electron rich phenothiazine improves charge carrier transport and extraction. The sulphur rich thiophene substituents contributes to this enhancement. Its flat and rigid structure, along with the strong electron delocalisation, extensive molecular conjugation, and S-S interactions, results in hole selective layers that exhibit high hole mobility and conductivity. The molecule exhibits optimal electron blocking, forming a fully functional hole-selective layer. This combination of enhanced crystallisation and effective charge selectivity makes it a unique high performing system with superior performance to PEDOT and MeO-2PACz hole transporting layers in perovskite solar cells.

A second aspect of the invention relates to a method for preparing a self-assembled monolayer for perovskite solar cells comprising the steps of
a. providing a compound according to the first aspect of the invention,
b. providing an ITO substrate,
c. activating the ITO substrate,
d. depositing the compound according to clams 1 to 20 onto the substrate,
e. annealing the substrate.

In certain embodiments, the compound according to the first aspect of the invention is deposited onto the substrate through spin-coating

In certain embodiments, the substrate is annealed at 100 °C.

The invention is further illustrated by the following examples and figures, from which further embodiments and advantages can be drawn. These examples are meant to illustrate the invention but not to limit its scope.

### Description of the Figures

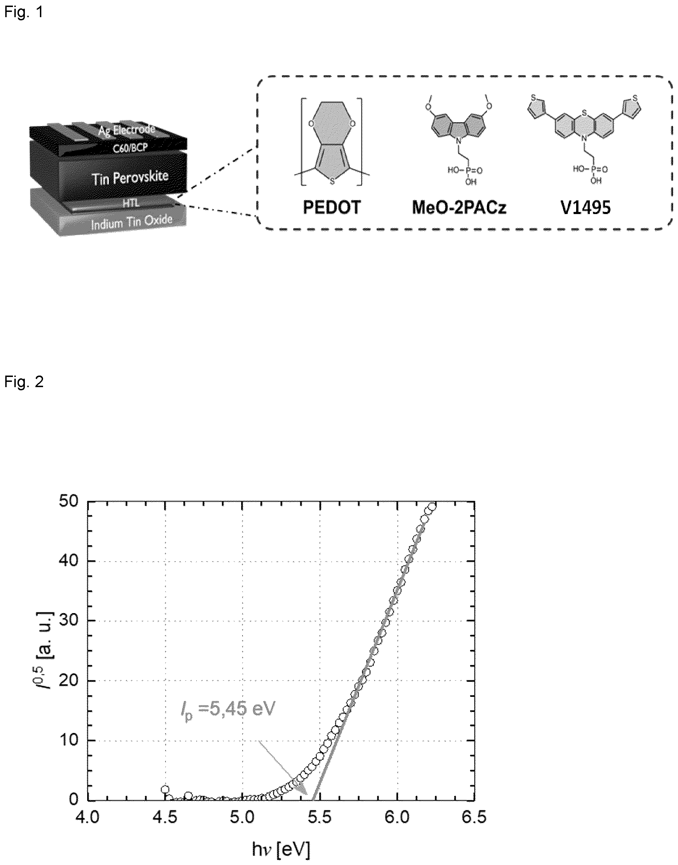

- Fig. 1: shows the architecture of a tin based perovskite solar cell containing a SAM (V1495) according to the present invention.
- Fig. 2: shows solar cells device data demonstrating capability of SAM containing thiophene groups. Tin-based FASNI₃ perovskite having shallow energetics with valance band energy of -4.83 eV was used. Data indicate the capabilit of SAM containing thiophene groups to change energetics of SAM.

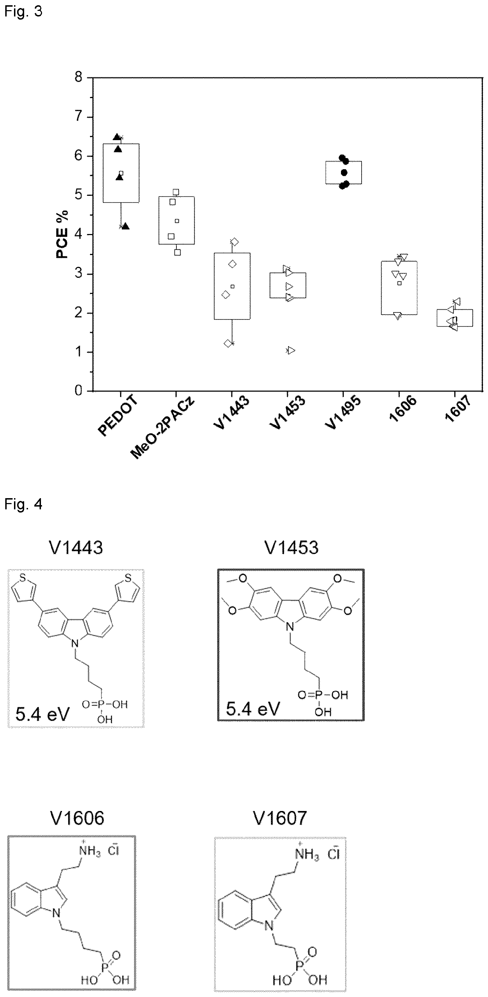

- Fig. 3: shows the performance of tin-based perovskite solar cells with a SAM (V1495) according to the present invention, compared to other molecules V1443, V1453, V1606 and V1607. The box plots show the mean value (centre line).
- Fig. 4: shows molecular structures the compounds V1443, V1453, V1606 and V1607.

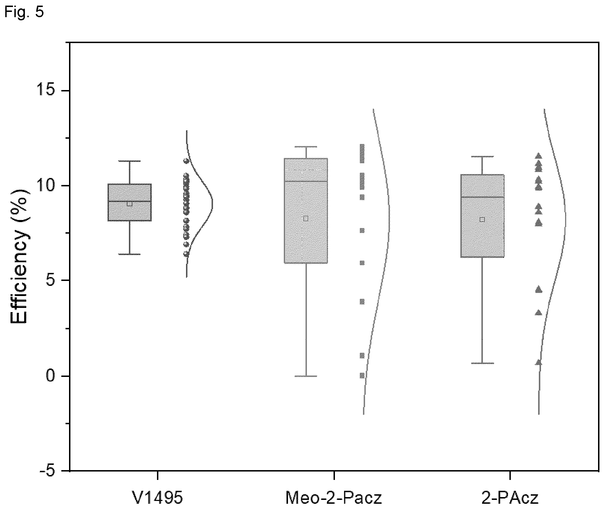

- Fig. 5: shows the efficiency of tin-lead (with 50/50% of Sn/Pb composition) perovskite solar cells containing SAM V1495 compared to 2PACz and MeO-2PACz. PCE boxplots show that SAM V1495 outperform state-of-the-art SAMs in terms of average efficiency.

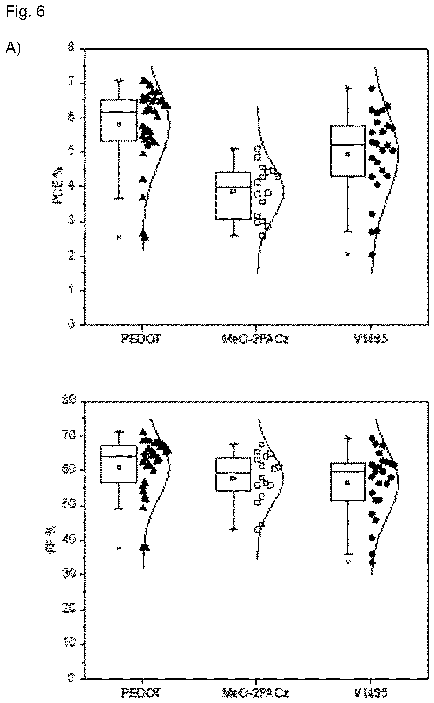

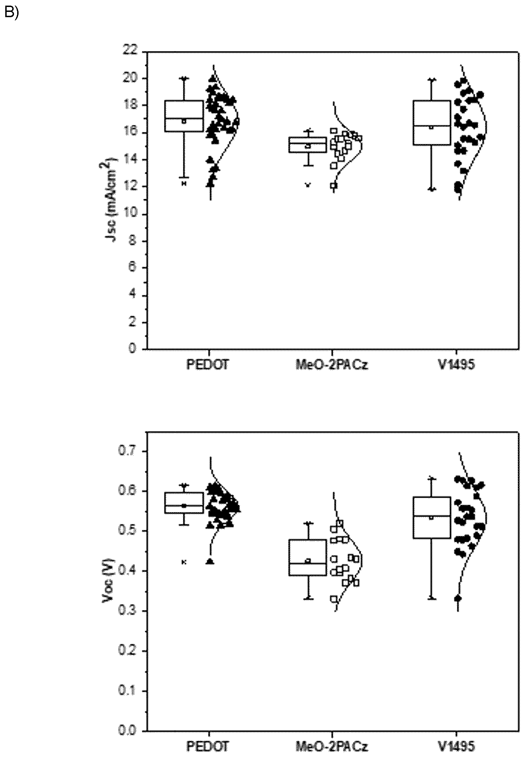

- Fig 6.: shows boxplots for PEDOT, spin-coated MeO-2PACz and spin-coated V1495 all prepared by the spincoating method. V1495 shows better performance than state-of-the-art MeO-2PACz SAM.

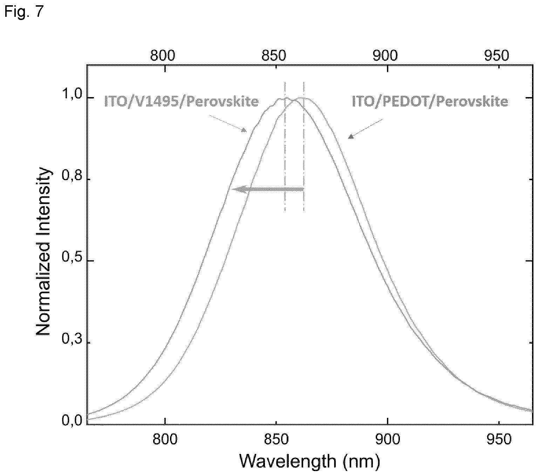

- Fig. 7: shows a steady-state photoluminescence spectrum of perovskite solar cells containing PEDOT HTL, V1495 SAM and ITO. The blue shift of the V1495 containing perovskite solar cells indicates a lower concertation of defects in the crystal lattice and better crystallinity.
- Fig. 8: shows the performance (PCE) and Voc(V) of perovskite solar cells containing PEDOT or SAM V1495. For V1495 a PCE of 8.1 % was measured. The star marks the performance of the state of the art SAM MeO-2PACz. The box plots show the mean value (centre line).

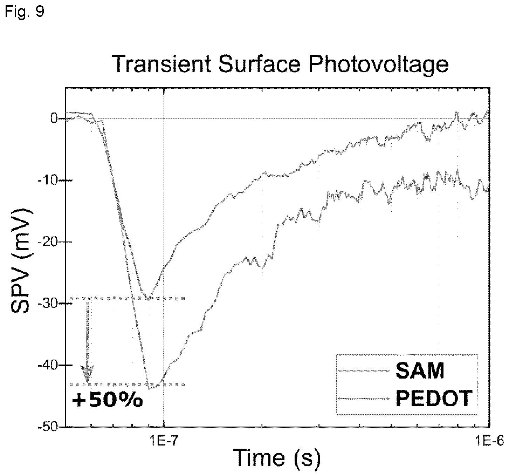

- Fig. 9: shows a surface photovoltage signal of a perovskite solar cell containing ITO/PEDOT (top signal) and ITO/V1495 (bottom signal). The V1495 SAM perovskite solar cell (bottom) showed a faster rise and higher intensity with respect to PEDOT, indicating a faster injection and higher selectivity for holes. The slower decay of the SAM indicates a reduction in defects at the interface for the SAM-Perovskite stack.

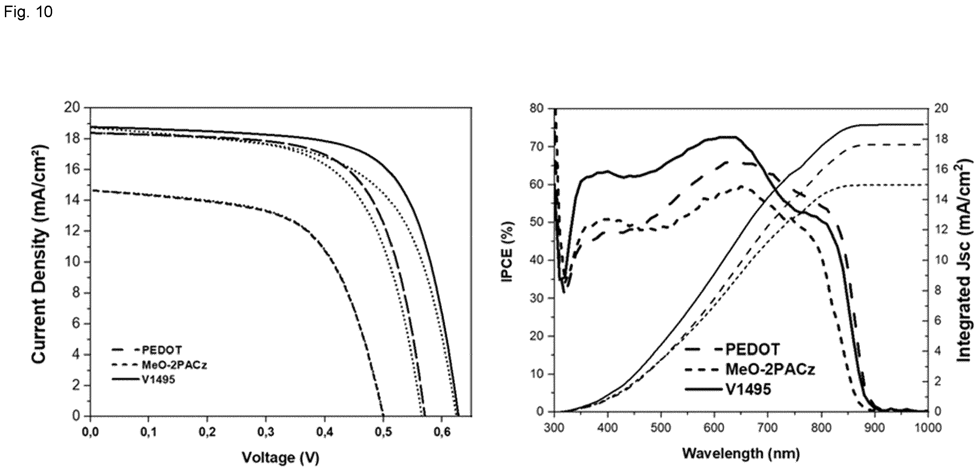

- Fig. 10: shows (left) J-V curves of spin coated TPZ-V1495, MeO-2PACz, and PEDOT. (right) IPCE and the integrated current density of PTZ-V1495 and PEDOT. A substantial improvement in short circuit current density (JSC) was observed with the spin coating of TPZ, achieving 19.8 mA cm⁻², compared to MeO-2PACz, which achieved 14.3 mA cm⁻² (left). The incident photon current efficiency measurement confirmed the high JSC of PTZ devices, with a value of 19.3 mA cm⁻² (right), whereas the reported value for MeO-2PACz is 13.7 mA cm⁻². The PCE increased from 5.8% for MeO-2PACz to 6.8% for TPZ.
- Fig. 11: shows (left) J-V curves of dip-coated TPZ-V1495, MeO-2PACz, and PEDOT. (right) IPCE and the integrated current density of PTZ-V1495 and PEDOT. Dip-coating a lower concentration of TPZ-V1495 successfully achieved better photovoltaic parameters, reaching a PCE of 8.1% for the TPZ device. Despite the PTZ HOMO level being deeper than that of MeO-2PACz, we observed a comparable V_{oc} value of 0.626 V for PTZ, while the reported values for MeO-2PACz and PEDOT are 0.637 V and 0.59 V, respectively.

### Examples

### Example 1: Preparation of {2-[3,7-Di(thiophen-3-yl)-10H-phenothiazin-10-yl]ethyl}phosphonic acid (2T-TPZ; V1495)

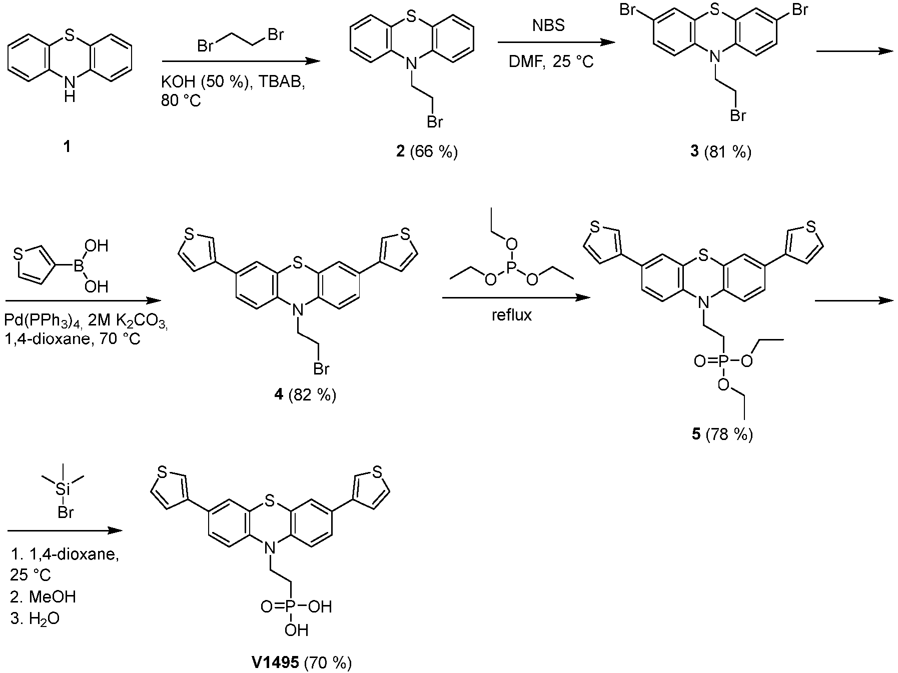

### 10-(2-bromoethyl)-10H-phenothiazine (2)

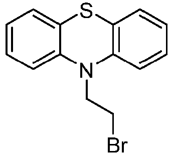

10*H*-Phenothiazine (1, 5 g, 25.1 mmol) was dissolved in 1,2-dibromoethane (54 ml, 627 mmol), followed by addition of 50 % KOH aqueous solution (14 ml, 125 mmol) and tetrabutylammonium bromide (1.21 g, 3.76 mmol). Reaction mixture was heated to 80 °C and conducted for 96 hours. After first 24 hours additional 50 % KOH aqueous solution (14 ml, 125 mmol) and tetrabutylammonium bromide (1.21 g, 3.76 mmol) were added. After termination of reaction (TLC, eluent acetone:n-hexane, 3:22), organic components were extracted with ethyl acetate, organic layer dried over anhydrous Na₂SO₄, filtered and solvent removed under reduced pressure. Crude product was purified by column chromatography (eluent acetone:n-hexane, 3:22). Product obtained as yellow crystals (5.12 g, 66 % yield). M.p. 78-80 °C. ¹H NMR (400 MHz, DMSO-d₆): δ 7.24 - 7.13 (m, 4H), 7.04 (d, *J =* 8.1 Hz, 2H), 6.97 (t, *J =* 7.4 Hz, 2H), 4.30 (t, *J=* 6.3 Hz, 2H), 3.74 (t, *J=* 6.3 Hz, 2H) ppm. ¹³C NMR (101 MHz, DMSO-d6): δ 143.96, 127.71, 127.26, 123.99, 122.91, 115.76, 48.36, 29.78 ppm. Anal. calcd. for C₁₄H₁₂BrNS: C 54.91, H, 3.95, N, 4.57; found: C 55.07, H 3.85, N 4.42.

### 3,7-Dibromo-10-(2-bromoethyl)-10H-phenothiazine (3)

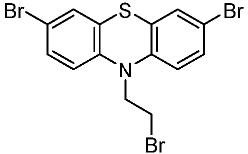

10-(2-Bromoethyl)-10*H*-phenothiazine (**2**, 2 g, 6.53 mmol) was dissolved in DMF (25 ml) and afterwards N-bromosuccinimide (2.38 g, 13.4 mmol) was added portionwise. Reaction conducted overnight at 25 °C. After termination of reaction (TLC, eluent acetone:*n*-hexane, 1:24) organic components extracted with ethyl acetate, organic layer dried over anhydrous Na₂SO₄, filtered and solvent evaporated under reduced pressure. Crude product was purified by column chromatography (eluent acetone:n-hexane, 1:24), resulting in white crystals (2.44 g, 81 % yield) as a product. M.p. 144-145 °C.

¹H NMR (400 MHz, DMSO-d₆): δ 7.39 - 7.32 (m, 4H), 6.98 (d, *J =* 8.6 Hz, 2H), 4.26 (t, *J =* 6.2 Hz, 2H), 3.70 (t, *J* = 6.1 Hz, 2H) ppm. ¹³C NMR (101 MHz, DMSO-d₆): δ 143.05, 130.43, 129.21, 125.96, 117.70, 114.52, 48.49, 29.58 ppm. Anal. calcd. for C₁₄H₁₀Br₃NS: C 36.24, H, 2.17, N, 3.02; found: C 36.50, H 2.02, N 2.88.

### 10-(2-Bromoethyl)-3,7-di(thiophen-3-yl)-10H-phenothiazine (4)

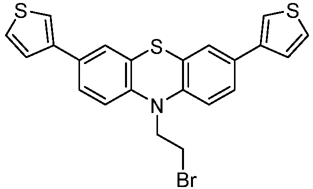

3,7-Dibromo-10-(2-bromoethyl)-10*H*-phenothiazine (**3,** 1.5 g, 3.23 mmol) was dissolved in anhydrous 1,4-dioxane (40 ml) under argon atmosphere, followed by addition of 3-thienylboronic acid (1.03 g, 8.08 mmol), Pd(PPh₃)₄ (0.37 g, 0.32 mmol) and K₂CO₃ 2M aqueous solution (5.9 ml, 9.69 mmol). Reaction conducted at 80 °C under inert argon atmosphere for 24 hours. After termination of reaction (TLC, eluent acetone:n-hexane, 2:23), reaction mixture was cooled down and filtered through celite which was washed with THF. Organic solvent was evaporated, and the crude product was purified by column chromatography using acetone:*n-*hexane (2:23) as an eluent resulting yellow crystals (1.24 g, 82 %) as a product. M.p. 177.5-179 °C (melting and decomposition). ¹H NMR (400 MHz, DMSO-d₆): δ 7.82 (d, *J=* 1.1 Hz, 2H), 7.62 - 7.58 (m, 2H), 7.57 - 7.48 (m, 6H), 7.10 - 7.01 (m, 2H), 4.35 (t, *J* = 6.1 Hz, 2H), 3.81 - 3.73 (m, 2H) ppm. ¹³C NMR (101 MHz, DMSO-d₆): δ 142.55, 140.20, 130.20, 127.03, 126.00, 125.44, 124.65, 124.06, 120.12, 115.95, 48.46, 29.86 ppm. Anal. calcd. for C₂₂H₁₆BrNS₃: C 56.17, H, 3.43, N, 2.98; found: C 56.40, H 3.30, N 2.71.

### Diethyl {2-[3,7-di(thiophen-3-yl)-10H-phenothiazin-10-yl]ethyl}phosphonate (5)

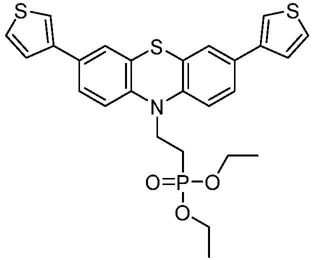

Diethyl {2-[3,7-di(thiophen-3-yl)-10*h*-phenothiazin-10-yl]ethyl}phosphonate **(4,** 1.2 g, 2.55 mmol) was suspended in triethyl phosphite (3 ml, 51 mmol) and the reaction was refluxed overnight. After termination of reaction (TLC, eluent acetone:n-hexane, 7:18), solvent was removed under reduced pressure and the crude product was purified by column chromatography (eluent acetone:n-hexane, 7:18). Product obtained as yellow resin (1.05 g, 78 %). ¹H NMR (400 MHz, DMSO-d₆): δ 7.83 (s, 2H), 7.63 - 7.52 (m, 8H), 7.05 (d, *J* = 8.4 Hz, 2H), 4.15 - 3.94 (m, 6H), 2.35 - 2.20 (m, 2H), 1.24 (t, *J* = 7.1 Hz, 6H) ppm. ¹³C NMR (101 MHz, DMSO-d₆): δ 142.43, 140.16, 130.00, 126.99, 125.96, 125.41, 124.51, 123.37, 120.04, 115.49, 61.35, 61.29, 40.93, 23.79, 22.45, 16.31, 16.26 ppm. Anal. calcd. for C₂₆H₂₆NO₃PS₃: C 59.18, H, 4.97, N, 2.65; found: C 59.41, H 4.89, N 2.88.

### {2-[3,7-Di(thiophen-3-yl)-10h-phenothiazin-10-yl]ethyl}phosphonic acid (V1495)

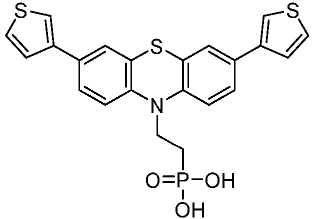

Diethyl {2-[3,7-di(thiophen-3-yl)-10*H*-phenothiazin-10-yl]ethyl}phosphonate **(5, 1** g, 1.89 mmol) was dissolved in anhydrous 1,4-dioxane (25 ml) under argon atmosphere. Afterwards, bromotrimethylsilane (2.5 ml, 18.9 mmol) was added dropwise and reaction was stirred overnight at 25 °C. After consumption of phosphonate **5** (TLC, eluent acetone:n-hexane, 8:17) methanol (0.8 ml, 18.9 mmol) was added and stirring continued for 2 hours. Afterwards, distilled water was added dropwise until precipitate was formed and stirring continued overnight. Product was purified by dissolving in minimum amount of THF, precipitating into 20-fold excess of n-hexane, filtering, and washing with n-hexane to give brown crystals (0.62 g, 70 % yield). M.p. 198-200 °C (melting and decomposition). ¹H NMR (400 MHz, DMSO-d₆): δ 7.80 (s, 2H), 7.62 - 7.57 (m, 2H), 7.58 - 7.47 (m, 6H), 7.01 (d, *J* = 8.4 Hz, 2H), 4.13 - 3.98 (m, 2H), 2.16 - 2.00 (m, 2H) ppm. ¹³C NMR (101 MHz, DMSO-d₆): δ 142.33, 140.16, 129.89, 126.98, 125.96, 125.42, 124.45, 122.75, 119.98, 115.17, 41.98, 26.33, 25.03 ppm. Anal. calcd. for C₂₂H₁₈NO₃PS₃: C 56.04, H, 3.85, N, 2.97; found: C 56.20, H 4.01, N 2.83.

Preparation of {2-[3,7-Di(thiophen-3-yl)-10h-phenoxazin-10-yl]ethyl}phosphonic acid **(V1688)**

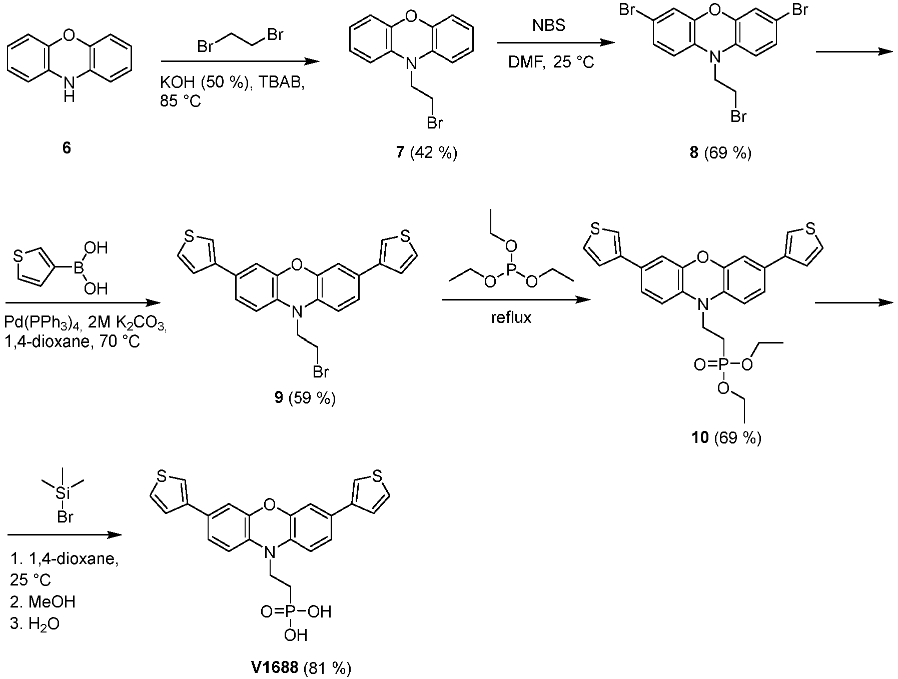

### 10-(2-bromoethyl)-10H-phenoxazine (7)

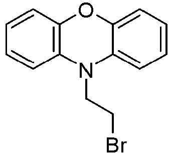

10*H*-phenoxazine **(6,** 3 g, 16.4 mmol) was dissolved in 1,2-dibromoethane (35.3 ml, 409 mmol), followed by addition of 50 % KOH aqueous solution (9 ml, 82 mmol) and tetrabutylammonium bromide (0.79 g, 2.45 mmol). Reaction mixture was heated to 85 °C and conducted for 48 hours. After first 24 hours additional 50 % KOH aqueous solution (9 ml, 82 mmol) and tetrabutylammonium bromide (0.79 g, 2.45 mmol) were added. After termination of reaction (TLC, eluent acetone:*n*-hexane, 3:22), organic components were extracted with ethyl acetate, organic layer dried over anhydrous Na₂SO₄, filtered and solvent removed under reduced pressure. Crude product was purified by column chromatography (eluent acetone:n-hexane, 2:23). Product obtained as yellow crystals (1.43 g, 42 % yield). M.p. 64-65 °C.

¹H NMR (400 MHz, DMSO-d₆): δ 6.85 (t, *J* = 7.3 Hz, 2H), 6.74 (d, *J* = 8.1 Hz, 2H), 6.69 (t, *J* = 7.2 Hz, 4H), 4.00 (t, *J* = 7.3 Hz, 2H), 3.62 (t, *J* = 7.3 Hz, 2H) ppm. ¹³C NMR (101 MHz, DMSO-d₆): δ 144.00, 132.25, 124.12, 121.45, 115.29, 112.33, 44.88, 27.96 ppm. Anal. calcd. for C₁₄H₁₂BrNO: C 57.95, H 4.17, N 4.83; found: C 57.85, H 4.10, N 4.72.

### 3,7-Dibromo-10-(2-bromoethyl)-10H-phenoxazine (8)

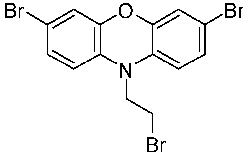

10-(2-Bromoethyl)-10*H*-phenoxazine **(7**, 1.4 g, 4.93 mmol) was dissolved in DMF (20 ml) and afterwards *N*-bromosuccinimide (1.85 g, 10.4 mmol) was added portion wise. Reaction conducted overnight at 25 °C. After termination of reaction (TLC, eluent THF:*n*-hexane, 1:24) organic components extracted with ethyl acetate, organic layer dried over anhydrous Na₂SO₄, filtered and solvent evaporated under reduced pressure. Crude product was purified by column chromatography (eluent acetone:*n*-hexane, 3:22) and then recrystallized from acetone, resulting in white crystals (1.52 g, 69 % yield) as a product. M.p. 205-206.5 °C (melting and decomposition).

¹H NMR (400 MHz, THF-d₈): δ 6.97 (dd, *J* = 8.6, 1.8 Hz, 2H), 6.81 (d, *J* = 1.9 Hz, 2H), 6.61 (d, *J* = 8.6 Hz, 2H), 3.95 (t, *J* = 7.8 Hz, 2H), 3.57 - 3.51 (m, 2H) ppm. ¹³C NMR (101 MHz, THF-d₈): δ 146.17, 132.66, 127.83, 119.59, 114.35, 113.82, 46.64, 26.68. Anal. calcd. for C₁₄H₁₀Br₃NO: C 37.54, H 2.25, N 3.13; found: C 37.43, H 2.38, N 3.20.

### 10-(2-Bromoethyl)-3,7-di(thiophen-3-yl)-10H-phenoxazine (9)

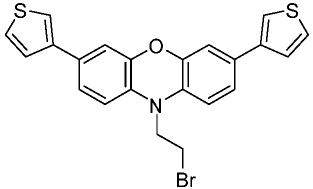

3,7-Dibromo-10-(2-bromoethyl)-10*H*-phenoxazine **(8,** 1.5 g, 3.14 mmol) was dissolved in anhydrous 1,4-dioxane (45 ml) under argon atmosphere, followed by addition of 3-thienylboronic acid (1 g, 7.85 mmol), Pd(PPh₃)₄ (0.91 g, 0.78 mmol) and K₂CO₃ 2M aqueous solution (4.7 ml, 9.4 mmol). Reaction conducted at 70 °C under inert argon atmosphere for 24 hours. After termination of reaction (TLC, eluent chloroform:n-hexane, 2:23), reaction mixture was cooled down and filtered through celite which was washed with THF. Organic solvent was evaporated, and the crude product was purified by column chromatography using chloroform:n-hexane (2:23) as an eluent resulting yellow crystals (0.90 g, 59 %) as a product. M.p. 210-211 °C.

¹H NMR (400 MHz, DMSO-d₆): δ 7.76 (s, 2H), 7.58 (m, 2H), 7.49 (d, *J=* 4.8 Hz, 2H), 7.23 (d, *J=* 8.0 Hz, 2H), 7.08 (s, 2H), 6.80 (d, *J=* 8.4 Hz, 2H), 4.08 (t, *J=* 6.9 Hz, 2H), 3.67 (t, *J=* 7.0 Hz, 2H) ppm. ¹³C NMR (101 MHz, DMSO-d₆): δ 144.06, 140.38, 130.92, 128.94, 126.95, 125.90, 121.71, 119.68, 112.93, 112.73, 44.81, 28.23 ppm. Anal. calcd. for C₂₂H₁₆BrNS₂O: C 58.15, H 3.55, N 3.08; found: C 58.09, H 3.50, N 3.16.

### Diethyl {2-[3,7-di(thiophen-3-yl)-10H-phenoxazin-10-yl]ethyl}phosphonate (10)

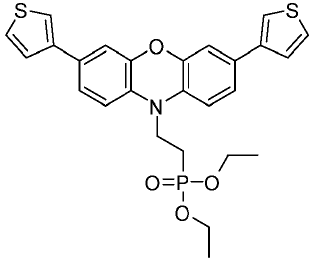

10-(2-Bromoethyl)-3,7-di(thiophen-3-yl)-10*H*-phenoxazine **(9,** 0.9 g, 1.92 mmol) was suspended in triethyl phosphite (6.6 ml, 38 mmol) and the reaction was refluxed overnight. After termination of reaction (TLC, eluent acetone:n-hexane, 7:18), solvent was removed under reduced pressure and the crude product was purified by column chromatography (eluent acetone:n-hexane, 7:18). Product obtained as yellow crystals (0.68 g, 69 %). M.p. 122.5-123.5 °C (melting and decomposition).

¹H NMR (400 MHz, DMSO-d₆): δ 7.77 (s, 2H), 7.60 - 7.56 (m, 2H), 7.50 (d, *J* = 4.9 Hz, 2H), 7.25 (d, *J* = 8.3 Hz, 2H), 7.10 (s, 2H), 6.73 (d, *J* = 8.4 Hz, 2H), 4.12 - 4.00 (m, 4H), 3.84 (dd, *J =* 15.0, 8.2 Hz, 2H), 2.19 - 2.10 (m, 2H), 1.27 (t, *J=* 7.0 Hz, 6H) ppm. ¹³C NMR (101 MHz, DMSO-d₆): δ 144.28, 140.38, 130.78, 128.70, 126.88, 125.86, 121.71, 119.56, 112.81, 112.19, 61.45, 61.39, 37.47, 21.82, 20.48, 16.34, 16.29 ppm. Anal. calcd. for C₂₆H₂₆NO₄PS₂: C 61.04, H 5.12, N 2.74; found: C 60.98, H 5.17, N 2.78.

### {2-[3,7-Di(thiophen-3-yl)-10h-phenoxazin-10-yl]ethyl}phosphonic acid (V1688)

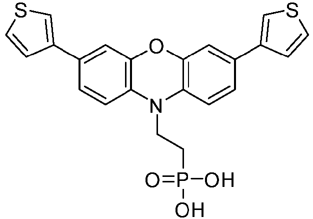

Diethyl {2-[3,7-di(thiophen-3-yl)-10*H*-phenoxazin-10-yl]ethyl}phosphonate **(10,** 0.68 g, 1.32 mmol) was dissolved in anhydrous 1,4-dioxane (12 ml) under argon atmosphere. Afterwards, bromotrimethylsilane (1.7 ml, 13.2 mmol) was added dropwise and reaction was stirred overnight at 25 °C. After consumption of phosphonate **10** (TLC, eluent acetone:n-hexane, 8:17) methanol (0.8 ml, 18.9 mmol) was added and stirring continued for 2 hours. Afterwards, distilled water was added dropwise until precipitate was formed and stirring continued overnight. Product was purified by dissolving in minimum amount of THF, precipitating into 20-fold excess of *n*-hexane, filtering and washing with n-hexane to give green crystals (0.49 g, 81 % yield). M.p. 218-219 °C (melting and decomposition).

¹H NMR (400 MHz, DMSO-d₆): δ 7.76 (s, 2H), 7.61 - 7.55 (m, 2H), 7.49 (d, *J* = 4.9 Hz, 2H), 7.25 (d, *J=* 7.9 Hz, 2H), 7.10 (s, 2H), 6.70 (d, *J* = 8.4 Hz, 2H), 3.87 - 3.76 (s, 2H), 2.01 - 1.84 (m, 2H) ppm. ¹³C NMR (101 MHz, DMSO-d₆): δ 144.69, 140.84, 131.33, 129.05, 127.31, 126.31, 122.22, 119.98, 113.27, 112.30, 38.80, 24.50, 23.22 ppm. Anal. calcd. for C₂₂H₁₈NO₄PS₂: C 58.01, H 3.98, N 3.08; found: C 57.91, H 4.09, N 2.96.

### Example 2: Photoelectrical measurements

The solid-state ionization potential (*l*ₚ) of the layer of the synthesized **V1495** was measured by the electron photoemission in the air method. The sample for the ionization energy measurement was prepared by dissolving material in THF, and the solutions was coated on Al plates that were pre-coated with a ~0.5 µm thick methylmethacrylate and methacrylic acid copolymer adhesive layer. The thickness of the transporting material layer was 0.5-1 µm. The samples were illuminated with monochromatic light from the quartz monochromator with a deuterium lamp. The power of the incident light beam was (2-5)·10-8 W. The negative voltage of -300 V was supplied to the sample substrate. The counter electrode with the 4.5×15 mm² slit for illumination was placed at an 8 mm distance from the sample surface. The counterelectrode was connected to the input of the BK2-16 type electrometer working in the open input regime for the photocurrent measurement. The 10-15 -10-12 A strong photocurrent was flowing in the circuit under illumination. Photocurrent I is strongly dependent on the incident light photon energy hv. The I0.5 =f(hv) dependence chart was plotted. The linear part of this dependence was extrapolated to the hv axis, and the *l*ₚ value was determined as the photon energy at the interception point.

### Example 3: Preparing a self-assembled monolayer on ITO substrates

ITO substrates were subsequently cleaned in a Mucasol solution (2% in DI-water), deionized water, acetone, and 2-propanol, each for 15 minutes in an ultrasonic bath. Afterwards, the surface was "activated" for 10-15 minutes in an UV-O₃ cleaner, which is a crucial step before SAM deposition. The 120 µL of SAM solution (1 mg/ml in ethanol) was spin-coated (with the rest time of ~5 s) at 5000 rpm for 30s, after which the substrate was annealed at 100°C for 3-10 min. Afterwards, the ITO substrates were dynamically washed (5000 rpm, 30 s) with 120 µL of pure ethanol.

### Example 4: Charge selectivity

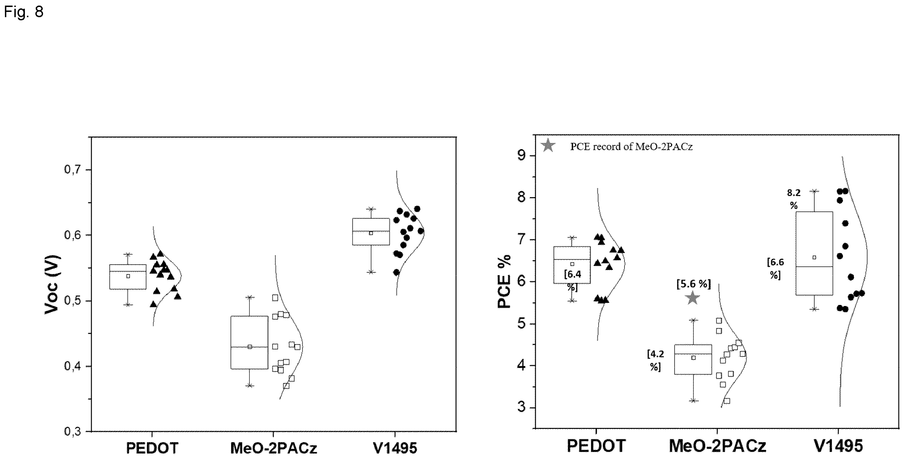

Transient surface photovoltage (trSPV) measurements were performed on half stacks to determine the hole-selectivity and charge injection capabilities of PEDOT and SAM. Measuring only the HTL half stack, carriers generated by the laser excitation will be separated or not depending on the properties of the HTL only, without any influence from the ETL side. The SPV signal is the direct sign of charge separation. The resulting SPV signal measured from the SAM samples showed a faster rise and higher intensity with respect to PEDOT, indicating respectively faster injection and higher selectivity for holes (see Fig. 8). The peak of both signals is detected at times shorter than 1E-7 s and then decays exponentially. This fast decay is expected in a highy p-doped Sn-based perovskite. The decay for the SAM is slightly slower though, possibly indicating a reduction in defects at the interface for the SAM-Perovskite stack. This novel measuring technique highlighted the superior charge extraction and selection capabilities for the new SAM with respect to PEDOT, the state of the art HTL for tin perovskite.

### Cited prior art documents:

1. Song, Donghoon, et al. "Mixed Self-Assembled Monolayers for High-Photovoltage Tin Perovskite Solar Cells." ACS Energy Letters 9.4 (2024):1466-1472.
2. Aktas, Ece, et al. "One-Step Solution Deposition of Tin-Perovskite onto a Self-Assembled Monolayer with a DMSO-Free Solvent System." ACS Energy Letters 8.12 (2023): 5170-5174.
3. Galvis, Carlos E. Puerto, et al. "Challenges in the design and synthesis of self-assembling molecules as selective contacts in perovskite solar cells." Chemical Science (2024).

All scientific publications and patent documents cited in the present specification are incorporated by reference herein.

## Claims

1. A compound comprising formula (I) 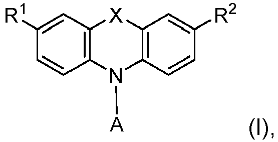 wherein
X is selected from the group consisting of -S-, -Se-, -O-, -Te-, -NH-, -C(CH₃)₂-, -S(=O)-, -(O=)S(=O)-, and -C(=O)-;
A is an anchoring group, wherein the anchoring group is selected from the groups consisting of
• -C₁-C₁₈-alkyl-PO₃H₂, -C₁-C₁₈-alkyl-COOH, -C₁-C₁₈-alkyl-B(OH)₂,
• 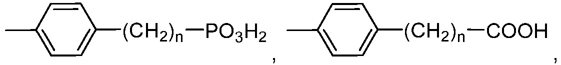 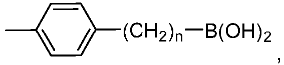 wherein n is 0, 1 or 2,
• 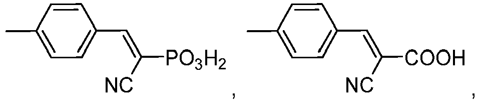
• 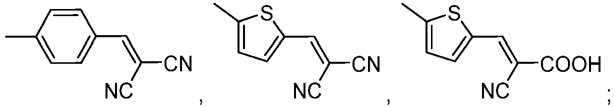
R¹ and R² are each selected from a mono-hetero aromatic moiety or a di-hetero aromatic moiety.

2. The compound according to any of the preceding claims, wherein X is selected from - S-, -Se-, -O-, -Te-, -NH-, and -C(CH₃)₂-, particularly, wherein X is selected from -S-, - Se-, and -O-, more particularly, wherein X is selected from -S- and -O-.

3. The compound according to any of the preceding claims, wherein X is -S-.

4. The compound according to any of the preceding claims, wherein A is selected from the groups consisting of
• -C₁-C₁₈-alkyl-PO₃H₂, -C₁-C₁₈-alkyl-COOH, -C₁-C₁₈-alkyl-B(OH)₂,
• 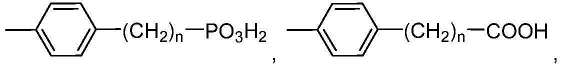 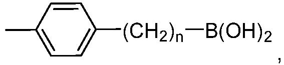 wherein n is 0, 1 or 2,
•

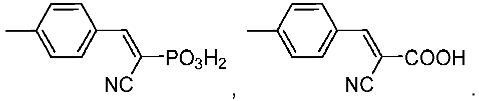

5. The compound according to any of the preceding claims, wherein A is selected from the groups consisting of
• -C₁-C₁₈-alkyl-PO₃H₂, -C₁-C₁₈-alkyl-COOH,
• 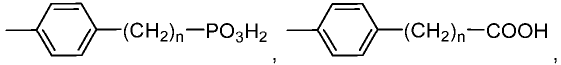 wherein n is 0, 1 or 2,
• 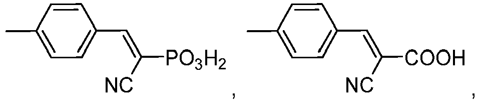 particularly, wherein A is selected from the groups consisting of
• -C₁-C₁₀-alkyl-PO₃H₂, -C₁-C₁₀-alkyl-COOH,
• 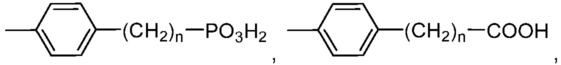 wherein n is 0, 1 or 2,
• 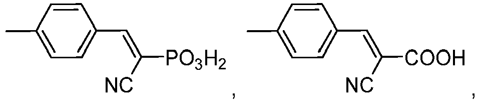 more particularly, wherein A is selected from the groups consisting of -C₁-C₁₀-alkyl-PO₃H₂, 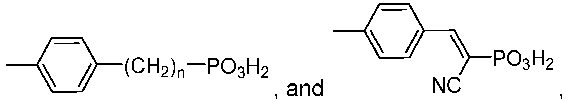 wherein n is 0, 1 or 2.

6. The compound according to any of the preceding claims, wherein A is selected from the groups consisting of -C₁-C₆-alkyl-PO₃H₂, 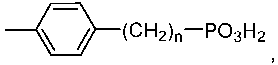 and 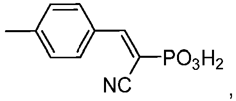 wherein n is 0, 1 or 2, particularly, wherein A is selected from the group consisting of -C₁-C₆-alkyl-PO₃H₂, more particularly, wherein A is selected from the group consisting of -C₁-C₄-alkyl-PO₃H₂ .

7. The compound according to any of the preceding claims, wherein the mono-hetero aromatic moiety of R¹ and R² comprises 5 to 9 atoms.

8. The compound according to any of the preceding claims, wherein the mono-hetero aromatic moiety of R¹ and R² or the di-hetero aromatic moiety of R¹ and R² each comprise, independently from one another 1 or 2 heteroatoms.

9. The compound according to any of the preceding claims, wherein the di-hetero aromatic moiety of R¹ and R² comprises 10 to 12 atoms.

10. The compound according to any of the preceding claims, wherein R¹ and R² are selected from any one of the moieties 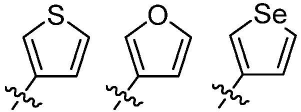 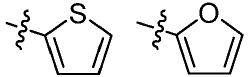 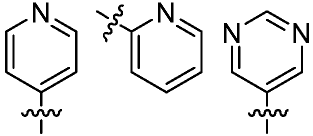 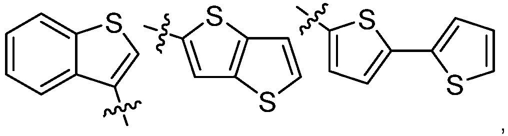
particularly
R¹ and R² are selected from any one of the moieties 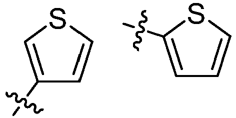 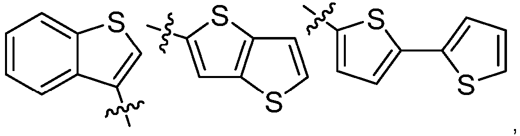 more particularly
R¹ and R² are selected from any one of the moieties

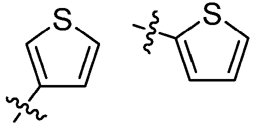

11. The compound according to any of the preceding claims, wherein the compound is of formula (II) 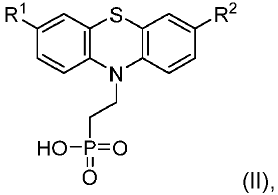 wherein R¹ and R² are defined according to claims 1 and 7 to 10.

12. The compound according to any of the preceding claims, wherein the compound is of formula (III)

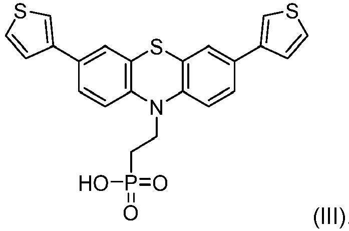

13. A method for preparing a self-assembled monolayer for perovskite solar cells comprising the steps of
a. providing a compound according to claims 1 to 12,
b. providing an ITO substrate,
c. activating the ITO substrate,
d. depositing the compound according to claims 1 to 12 onto the substrate,
e. annealing the substrate.

14. The method according to claim 13, wherein the compound according to claims 1 to 12 is deposited onto the substrate through spin-coating.

15. The method according to claims 13 to 14, wherein the substrate is annealed at 100 °C.
